(19) Europäisches Patentamt / European Patent Office / Office européen des brevets

(11) **EP 2 917 482 B1**

(12) **FASCICULE DE BREVET EUROPEEN**

(45) Date de publication et mention de la délivrance du brevet:
**03.01.2018 Bulletin 2018/01**

(21) Numéro de dépôt: **13803105.9**

(22) Date de dépôt: **05.11.2013**

(51) Int Cl.:
*G06F 17/10* (2006.01)    *G06F 17/50* (2006.01)
*E21B 47/10* (2012.01)

(86) Numéro de dépôt international:
**PCT/FR2013/052627**

(87) Numéro de publication internationale:
**WO 2014/072627 (15.05.2014 Gazette 2014/20)**

(54) **NOUVELLE MÉTHODOLOGIE DE DÉTERMINATION DES COURBES DE PRODUCTIVITÉ DES PUITS D'EXPLOITATION DE STOCKAGES ET GISEMENTS DE FLUIDES COMPRESSIBLES**

NEUE METHODE FÜR DIE BESTIMMUNG DER PRODUKTIVITÄTSKURVEN VON BOHRLÖCHERN FÜR BETRIEBSSPEICHERANLAGEN UND FLÜSSIGKEITSABLAGERUNGEN

NEW METHODOLOGY FOR DETERMINING THE CURVES OF PRODUCTIVITY FOR WELLS OPERATING STORAGE FACILITIES AND DEPOSITS OF FLUIDS.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.11.2012 FR 1260579**

(43) Date de publication de la demande:
**16.09.2015 Bulletin 2015/38**

(73) Titulaire: **Storengy**
**92270 Bois-Colombes (FR)**

(72) Inventeur: **HUGUET, Frédéric**
**F-95470 Fosses (FR)**

(74) Mandataire: **Delumeau, François Guy et al**
**Cabinet Beau de Loménie**
**158, rue de l'Université**
**75340 Paris Cedex 07 (FR)**

(56) Documents cités:
**EP-A1- 2 253 797        WO-A1-2009/082564**
**US-A1- 2009 276 100**

EP 2 917 482 B1

**Description**

Domaine technique et art antérieur

L'invention s'inscrit dans le domaine de l'exploitation de puits de stockages souterrains de fluides compressibles ou de gisements d'hydrocarbures, qu'il s'agisse de gisements naturels en milieu poreux ou de gaz de schiste (« shale gas ») ou de stocks artificiels. Les stockages considérés sont par exemple des stockages en aquifères ou dans des gisements déplétés.

Dans ce domaine, il est utile de caractériser au mieux la performance (ou productivité) des puits ou gisements d'hydrocarbures, pour une meilleure maîtrise technique et une meilleure exploitation économique de ceux-ci.

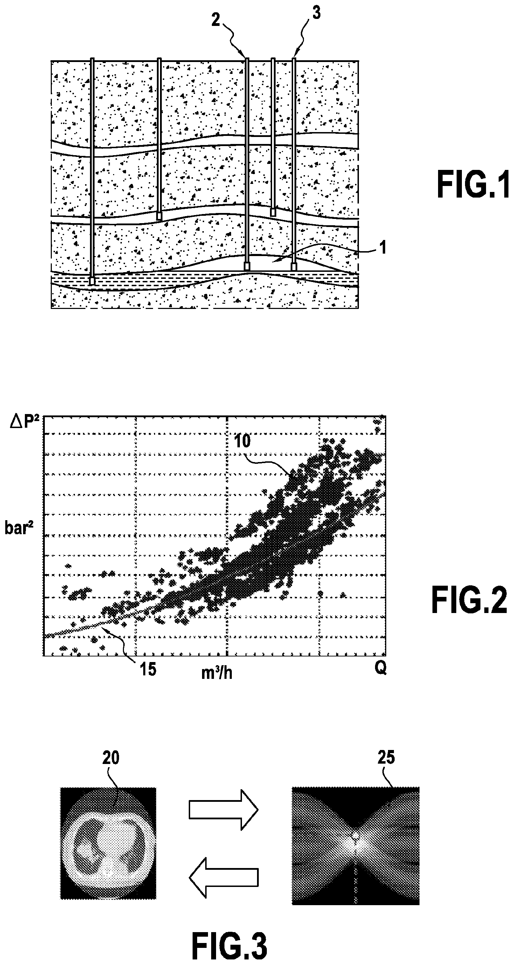

Un stockage est représenté en figure 1. Il comprend un réservoir 1, et on a figuré le puits de gisement 2, qui permet, via un manifold, de mesurer une pression de gisement, ainsi que le puits d'exploitation 3, par lequel circule le gaz, entrant ou sortant.

Classiquement, on utilise un espace de caractérisation de fonctionnement du stockage à deux dimensions, dans lequel sont tracées des courbes de performance. L'espace utilisé couramment est l'espace des points $(Q ; \Delta P^2)$, où Q est le débit de fluide entrant dans ou sortant du puits d'exploitation, et $\Delta P^2$ est la différence entre les carrés de la pression Pm mesurée à la sortie du puits d'exploitation 3 et la pression Pg du stockage au repos, ou pression de gisement, représentée par la pression mesurée par le puits de gisement 2.

Des mesures sont effectuées sur le puits d'exploitation 3 à différents débits et les points correspondants sont portés dans cet espace. Un tel espace est représenté en figure 2, où l'axe des abscisses est gradué en $m^3/h$ et l'axe des ordonnées est gradué en $bar^2$. Le nuage de points 10 est l'ensemble des mesures disponibles et utilisées.

On constate en général une certaine dispersion des mesures, typiquement dues à des erreurs de mesure, des interférences entre puits, des hydratations du puits, des venues d'eau, ainsi qu'à l'évolution de la performance au cours du temps.

L'existence de ces dispersions a pour conséquence que l'interprétation des mesures est un travail complexe nécessitant des procédures définies, impliquant éventuellement un opérateur humain qualifié.

Néanmoins il est généralement possible de déterminer un modèle mathématique pour rendre compte de ces mesures, et être en mesure d'extrapoler le comportement du stockage à d'autres circonstances.

Typiquement, le modèle mathématique utilisé est un modèle dans lequel les courbes de productivité sont représentées dans l'espace $(Q ; \Delta P^2)$ par une fonction parabolique d'ordonnée à l'origine égale à 0 et de pente à l'origine positive, écrite couramment $\Delta P^2 = IPa\ Q + IPb\ Q^2$ (avec IPa et IPb positifs) en utilisant deux coefficients notés IPa et IPb qualifiés de coefficients de productivité. Une telle fonction est représentée en référence 15, pour le nuage de points 10.

Les coefficients de productivité sont fonction physiquement des caractéristiques du sous-sol du stockage. Ils sont utilisés comme des données d'entrée pour le pilotage des stockages et gisements.

Pour les déterminer, une méthode consiste à procéder à une adaptation manuelle de ces coefficients pour chaque puits du stockage et, éventuellement, pour différents niveaux de remplissage du stockage. Cette méthode implique qu'un opérateur humain hautement qualifié mène régulièrement un travail délicat, difficile à évaluer, et pouvant être perçu comme dépendant de l'opérateur.

Une autre méthode est de calculer les coefficients de productivité par régression linéaire, en recherchant une relation linéaire entre $\Delta P^2/Q$ et Q. Le modèle est alors évalué par un algorithme dans l'espace $(Q ; \Delta P^2/Q)$. Cette méthode présente deux inconvénients : d'une part, en l'absence de contraintes sur la valeur des coefficients, on peut aboutir à des valeurs aberrantes du fait du bruit dans les valeurs mesurées. D'autre part, on obtient souvent des valeurs négatives pour le coefficient IPa si la pression du puits de gisement Pg mesurée n'est pas représentative ou si elle est entachée par des interférences entre puits.

Au final, la détermination des coefficients de productivité est difficile, peu pratique, et reste entachée d'erreur. Il subsiste un besoin d'une méthode facile à mettre en oeuvre et fiable. Mais dans le domaine concerné, aucune tendance technologique ou scientifique ne suggère une évolution particulière des méthodes existantes.

Dans un domaine totalement différent, on connait la transformée de Radon (J. Radon, On the détermination of functions from their integrals along certain manifolds 1917, in The radon transform and some of its applications, Annexe A, John Wiley & Sons, 1983), qui est une opération mathématique utilisée notamment en reconstruction d'images médicales de tomographie aux rayons X. Une telle application de la transformée de Radon est représentée en figure 3, où l'on voit le lien bijectif entre une structure dans un plan de coupe, ici une image médicale 20, et les mesures 25 (sinogramme) faites sous différents angles d'observation par l'appareil de tomographie.

La transformée de Radon, ainsi que l'opération inverse, la transformée de Radon inverse, sont utilisées en imagerie médicale ainsi que dans certaines techniques spécifiques dans le domaine de la sismique ou de la détection radar. Ainsi, dans le domaine de la sismique, on décompose, par la transformée de Radon, un champ d'ondes observées en ondes planes, ce qui facilite l'analyse des signaux.

De manière générale, la transformée de Radon a pour objet de convertir des données d'un système de coordonnées polaires à un système de coordonnées cartésiennes, par l'entremise d'intégrales curvilignes le long de droites repérées en coordonnées polaires.

Il n'a jamais été proposé ou suggéré d'utiliser cette opération mathématique dans le domaine de l'optimisation du calcul de la productivité des stockages de gaz, un domaine très différent des domaines dans lesquels la transformée de Radon est appliquée. On remarquera notamment que l'optimisation du calcul de la productivité des stockages n'est jamais faite avec des méthodes utilisant des coordonnées polaires, et que dans ce domaine on est amené de plus à traiter des données discrètes, sous forme de nuages de points, et non pas des données continues comme c'est le cas en imagerie médicale ou en sismique.

Les documents EP 2253797, US2009/0276100 et WO 2009082564 décrivent des procédés de caractérisation de performances de puits connus.

Définition de l'invention et avantages associés

Dans ce contexte, l'invention constitue une percée dans le domaine de l'exploitation de stockages de fluide compressible, puisqu'elle propose un procédé de caractérisation de la performance d'un stockage de fluide compressible, comprenant des étapes

- d'obtention d'une pluralité de points de fonctionnement,
- de définition d'une famille de modèles de fonctionnement,
- de dénombrement, pour chaque modèle de la famille, des points de la pluralité de points reproduits par ledit modèle,
- et de sélection pour la gestion dudit stockage d'au moins un modèle dans la famille de modèles sur la base d'au moins le résultat de l'étape de dénombrement.

Grâce à ce procédé, on est en mesure de disposer avec efficacité et reproductibilité d'un ou plusieurs modèles pour la gestion du stockage. Le procédé est basé sur un dénombrement discret qui s'apparente, intellectuellement, aux intégrations mises en oeuvre dans le cadre de la transformée de Radon appliquées à des données continues. Il n'est pas limité à l'utilisation d'un dénombrement (ou intégration ou somme) le long d'une droite, ni à l'utilisation de coordonnées polaires. Ce procédé ne découle aucunement de l'art antérieur relatif aux méthodes de caractérisation de la performance d'un stockage, ni de celui relatif à la transformation de Radon, deux domaines très éloignés avec des contraintes différentes. Une avancée concrète est proposée.

Par exemple, les points sont visualisés dans un espace de points d'abscisse proportionnelle à un débit d'exploitation, et d'ordonnée proportionnelle à la différence entre le carré d'une pression de puits d'exploitation et le carré d'une pression de puits de gisement ou stockage au repos. Il s'agit là d'un espace de caractérisation de fonctionnement connu et pratique pour les professionnels, comme évoqué plus haut.

Dans certains modes de réalisation, la famille de modèles est paramétrée par deux ou au moins deux valeurs numériques réelles. Par exemple, les modèles de la famille sont des modèles linéaires, ou, alternativement, les étapes de définition et de dénombrement comprennent une application de la transformée de Radon à la pluralité de points. Pour cette dernière variante, on peut par exemple rendre continu l'espace des données expérimentales en pixélisant celui-ci.

Dans d'autres modes de réalisation, la famille de modèles est paramétrée par trois valeurs numériques réelles. Par exemple, les modèles de la famille sont des modèles paraboliques ou hyperboliques.

Selon une caractéristique avantageuse, un résultat de dénombrement est pondéré de manière à être plus important si des points reproduits par le modèle sont dispersés le long du modèle. Cela permet de privilégier, pour la sélection, des modèles qui sont corroborés par les points expérimentaux sur une plus grande gamme de valeurs. Par exemple le résultat de dénombrement est pondéré de manière proportionnelle à la somme des variances des distances des coordonnées des points autour du modèle.

Selon les méthodes utilisées, la sélection est faite de manière au moins partiellement automatique, ou au moins partiellement manuelle par un opérateur humain. Eventuellement, la sélection comprend une identification d'au moins un maximum du résultat de dénombrement.

L'invention propose aussi un procédé de pilotage des débits ou pression d'un stockage de fluide compressible, utilisant un modèle sélectionné selon un procédé de caractérisation tel que présenté plus haut. La caractérisation peut être effectuée par un service spécialisé en traitement de données en provenance des stockages, ou à l'aide d'un logiciel spécialisé. Les résultats peuvent être utilisés ensuite pour le pilotage, qui peut être effectué par des personnes tierces, notamment un exploitant.

L'invention propose aussi un programme d'ordinateur comportant des instructions, qui, quand elles sont exécutées par un processeur, peuvent conduire à la mise en oeuvre d'un procédé de caractérisation tel qu'évoqué plus haut.

L'invention va maintenant être décrite en détails en relation avec les figures.

Brève description des figures

La figure 1, déjà évoquée, représente un stockage de gaz naturel.
La figure 2, déjà évoquée, représente le traitement de mesures effectuées sur un stockage selon l'art antérieur.
La figure 3, déjà évoquée, présente un domaine d'application de la transformée de Radon.
La figure 4 présente un traitement de mesures effectuées sur un stockage selon un premier mode de réalisation de l'invention.
La figure 5 présente un autre exemple de traitements de mesures selon l'invention.
La figure 6 présente une étude comparée des résultats obtenus avec l'invention et selon l'art antérieur.
La figure 7 présente des résultats obtenus avec un deuxième mode de réalisation, et les compare avec ceux obtenus avec le premier mode de réalisation.
La figure 8 présente l'interface graphique d'un logiciel mettant en oeuvre l'invention.
La figure 9 présente la mise en oeuvre du logiciel dans un mode de réalisation particulier de l'invention.

Il est précisé que ces figures sont fournies à titre illustratif, et ne doivent pas être interprétées comme indiquant des limitations à l'invention.

Description de modes de réalisation de l'invention

Selon l'invention, on analyse un nuage (ou ensemble) de points de mesure correspondant au fonctionnement d'un stockage de gaz naturel, ou d'un autre fluide compressible.

On présente tout d'abord le modèle général utilisé pour analyser les mesures effectuées sur les stockages, selon certains modes de réalisation de l'invention. Comme évoqué en introduction, ce modèle relie la différence des carrés des pressions noté $\Delta P^2 = |Pm^2-Pg^2|$, Pm et Pg désignant les pressions de puits d'exploitation et de puits de gisement, au débit d'exploitation, en soutirage ou en remplissage, noté Q. Le modèle est défini par l'équation suivante.

$$\Delta P^2 = IPa\ Q + IPb\ Q^2 + IPc \quad (1)$$

Une correction de mesure additive peut être apportée à Pg, mais elle ne sera pas présentée dans le présent document, par volonté de simplifier les équations.

En première analyse, on considère souvent que $\Delta P^2 = 0$ si Q = 0 ce qui implique que IPc = 0. Ainsi, le point (Q = 0 ; Pm = Pg) constitue dans cette hypothèse une contrainte de fonctionnement pour la modélisation.

Dans cette hypothèse, l'équation (1) peut donc s'écrire comme suit.

$$\Delta P^2 / Q = IPa + IPb\ Q \quad (2)$$

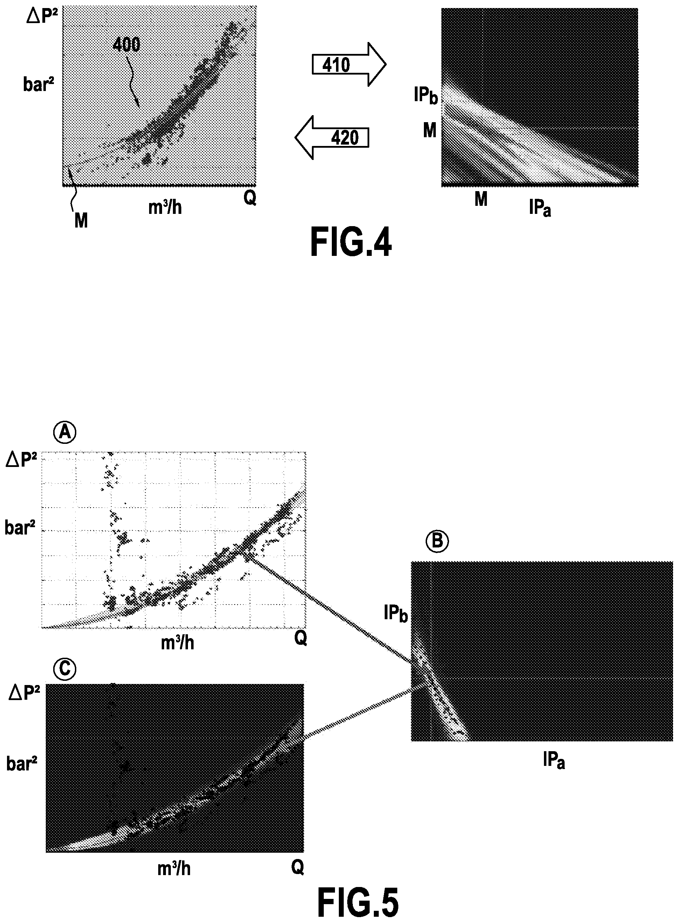

Le premier mode de réalisation de l'invention est basé sur cette équation, qualifiée de modèle linéaire. Un exemple de mise en oeuvre est représentée en **figure 4.** Dans la partie gauche de la figure, un nuage de points 400 est figuré, selon la représentation visuelle courante, dans l'espace (Q ; $\Delta P^2$). Dans ce premier mode de réalisation, un opérateur humain choisit des bornes inférieures et supérieures pour les coefficients IPa et IPb, et pour chaque couple de coefficients (IPa ; IPb) dans le cadre de ces bornes, la droite d'équation y = IPa + IPb x est considérée.

Un dénombrement des points du nuage de points qui sont reproduits par le modèle avec une marge d'erreur donnée est effectué. Pour cela, on dénombre les points dont la distance à la droite considérée est inférieure à une valeur prédéterminée dans l'espace (Q ; $\Delta P^2$/Q) (non représenté). Le dénombrement pourrait être fait en évaluant différemment la distance, comme ce serait le cas par exemple dans l'espace (Q ; $\Delta P^2$), sans pour autant s'écarter de l'invention.

Ce dénombrement constitue une intégration de ces points, chaque point ayant le même poids, opération intellectuellement similaire aux intégrales curvilignes de la transformée de Radon utilisée dans d'autres domaines.

Pour tenir compte de la répartition des points le long de la droite considérée, le résultat du dénombrement peut être, optionnellement mais avantageusement, multiplié par la somme de la variance, évaluée sur l'ensemble du nuage de points, des distances au modèle de chacun des points suivant l'axe des Q, et de la variance, évaluée sur l'ensemble du nuage de points, des distances au modèle de chacun des points suivant l'axe des $\Delta P^2$/Q.

La valeur obtenue est représentative de l'adéquation du modèle au nuage de points, et, dans la mise en oeuvre dans laquelle on pondère le résultat par la somme des variances évoquée, est augmentée si le nuage de points est étalé le long du modèle.

Pour chaque couple (IPa ; IPb), on reporte, au cours d'une étape 410, le résultat du dénombrement, éventuellement pondéré comme évoqué plus haut, sous la forme d'une intensité associée au point correspondant dans l'espace des valeurs (IPa ; IPb), représenté sur la partie droite de la figure. Sur une interface graphique, on utilise un code couleur ou une intensité lumineuse pour représenter l'intensité obtenue.

Ce procédé est reproduit pour toutes les valeurs de IPa et IPb dans les limites définies par les bornes minimales et maximales de ces variables, et on obtient la représentation de la partie droite de la figure, dans laquelle des zones de différentes intensités apparaissent. Ici, les zones de forte intensité ont une géométrie complexe avec plusieurs queues rattachées à une zone centrale, définissant plusieurs classes de modèles envisageables pour le nuage de points.

Au cours d'une étape 420, un opérateur humain ou un algorithme procède alors à la sélection, sur la base des intensités dans l'espace (IPa ; IPb), d'un ou de plusieurs points (ici un point noté M), correspondant à un ou plusieurs modèles du nuage de points selon l'équation (2), par exemple en identifiant un maximum. La sélection est effectuée pour la gestion du gisement ou du stockage considéré. Le modèle est ensuite utilisé par des spécialistes du pilotage de stockage, pour les opérations de gestion du stockage.

En **figure 5,** on a représenté la mise en oeuvre du même procédé avec d'autres valeurs de mesure.

Sur la partie A de la figure, le nuage de points est représenté dans l'espace (Q ; $\Delta P^2$). On constate une forte dispersion des points aux faibles valeurs de Q (faibles débits), qui est due ici à l'ennoiement du stockage.

On précise que la méthode de modélisation par régression linéaire connue de l'art antérieur est inefficace sur ce nuage de points du fait de cette dispersion.

La partie B de la figure montre les valeurs d'intensité obtenues pour les modèles étudiés, dans l'espace (IPa ; IPb). La géométrie des zones à forte intensité est cette fois simple, avec une seule zone de crête, ce qui permet par exemple de mettre en oeuvre un processus simple, humain ou automatisé, de pointé du maximum d'intensité.

On a fait figurer sur la partie A de la figure plusieurs modèles ayant une bonne adéquation avec le nuage de points, tel que cela ressort des valeurs d'intensité figurées en partie B de la figure.

Il est proposé dans un deuxième temps, sur la partie C de la figure, une retransposition des valeurs d'intensité dans l'espace (Q ; $\Delta P^2$). Pour ce faire, on peut tout d'abord remplacer par la valeur 0 la valeur d'intensité des points de l'espace (IPa ; IPb) dont l'intensité est inférieure à une valeur choisie, ce qui revient à exclure les modèles dont la pertinence est faible.

On applique ensuite une transformation inverse à celle appliquée précédemment. Les courbes dans le diagramme (Q ; $\Delta P^2$) correspondant aux points (IPa ; IPb) d'intensité non nulle sont représentées avec une valeur d'intensité (couleur ou luminosité sur l'interface graphique) égale à la valeur d'intensité du point (IPa ; IPb). Pour une représentation pixélisée de l'espace (Q ; $\Delta P^2$), on additionne, pour chaque pixel, les intensités des points (IPa ; IPb) des courbes correspondantes passant par le pixel.

Sur les parties A et C de la figure, on constate que les modèles choisis ne sont pas impactés par la dispersion des points aux faibles valeurs de Q (faibles débits), qui sont comme évoqué plus haut dues ici à l'ennoiement du stockage.

On voit bien ici les avantages qui ressortent de la méthode selon l'invention par rapport aux méthodes selon l'art antérieur.

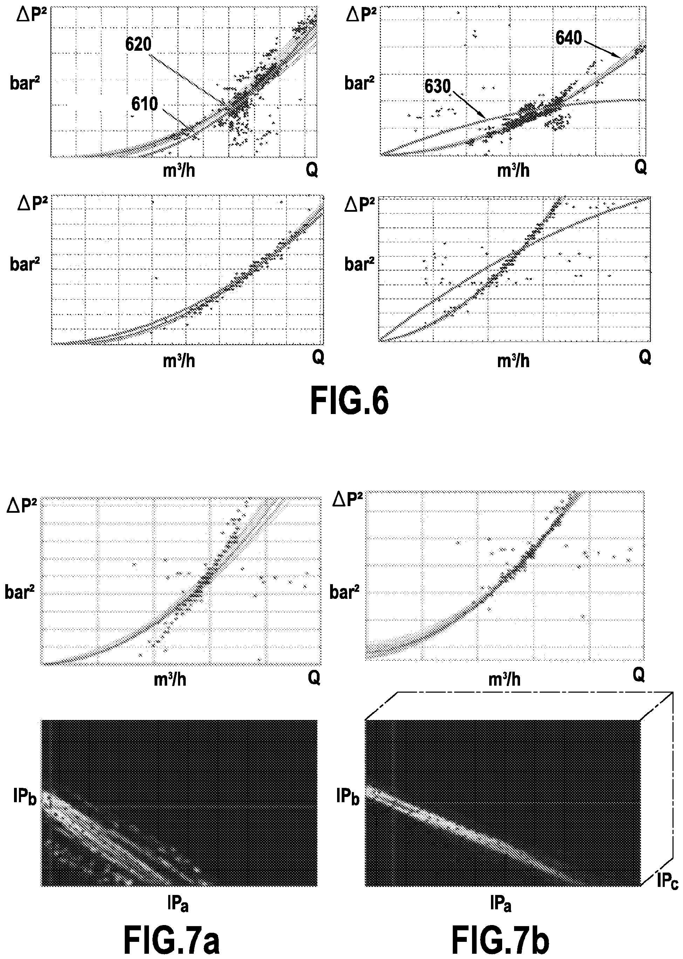

En **figure 6,** on a représenté, pour quatre nuages de points différents, les résultats obtenus par une méthode selon l'art antérieur, en l'occurrence ici la méthode par régression linéaire, et la méthode selon l'invention. Les nuages de points sont représentés dans l'espace (Q ; $\Delta P^2$).

Dans la partie à gauche et en haut de la figure, on a représenté un nuage de points de points et la courbe 610 obtenue par la méthode de l'art antérieur selon laquelle on utilise une régression linéaire dans l'espace (Q ; $\Delta P^2/Q$), ainsi que les courbes 620 obtenues par le processus de transformation suivi de transformation inverse selon l'invention. Dans ce cas, la courbe 610 obtenue par la méthode de l'art antérieur est satisfaisante, puisqu'elle ne constitue pas notamment une solution aberrante. Mais on voit que l'ensemble des courbes 620 obtenues par l'invention constitue une information riche et très intéressante pour l'industriel, qui obtient, grâce à l'invention, une idée de l'incertitude du modèle de performance.

Dans la partie à gauche et en bas de la figure, on a représenté, de manière tout à fait similaire, un deuxième nuage de points et les courbes obtenues selon l'art antérieur et selon la méthode selon l'invention. On constate ici que les courbes sont fortement superposées et que l'incertitude quant au modèle est très faible. Il faut remarquer que cela s'explique par le fait que le nuage de points traité est très régulier.

Dans la partie à droite et en haut de la figure, on a représenté un nuage de points plus éparpillé, pour lequel la méthode selon l'art antérieur utilisant une régression linéaire dans l'espace (Q ; $\Delta P^2/Q$) ne donne pas une solution satisfaisante. En effet, le modèle obtenu 630 est aberrant, notamment parce que le coefficient IPb est négatif, ce qui ne correspond pas à ce qui est observé dans la réalité. L'invention permet quant à elle d'obtenir des résultats très satisfaisants, avec un faisceau de courbes 640 physiquement cohérentes et indiquant une incertitude faible.

Dans la partie à droite et en bas de la figure, on a représenté un cas très similaire dans lequel la méthode de l'art antérieur donne un résultat aberrant, et la méthode selon l'invention un résultat tout à fait satisfaisant, avec une incertitude faible.

En **figure 7a,** on a représenté des résultats obtenus avec le premier mode de réalisation de l'invention, basé sur l'équation (2), pour un nuage de points qui donne avec l'équation (2) des valeurs d'intensité élevées pour des couples (IPa ; IPb) tels que IPa est négatif, ce qui n'est pas satisfaisant, car un modèle à IPa négatif implique que des débits positifs peuvent être associés à des valeurs de $\Delta P^2$ négatives.

En **figure 7b,** on a représenté un cas d'application d'un deuxième mode de réalisation de l'invention permettant de traiter un tel nuage de points.

Dans ce deuxième mode de réalisation, on utilise l'équation (1), avec IPc non nécessairement nul, pour modéliser les données. Un opérateur humain choisit des bornes inférieures et supérieures pour les coefficients IPa, IPb et IPc, et pour chaque triplet de coefficients (IPa ; IPb ; IPc) dans le cadre de ces bornes, la parabole d'équation y = IPa x + IPb $x^2$ + IPc est considérée. Le modèle est qualifié de modèle parabolique.

Un dénombrement des points du nuage de points dont la distance à la parabole considérée, dans l'espace (Q ; $\Delta P^2$), est inférieure à une valeur prédéterminée est effectué. Ces points sont raisonnablement reproduits par le modèle correspondant, avec la marge d'erreur correspondant à la valeur prédéterminée.

La valeur obtenue est représentative de l'adéquation entre le nuage de points et le modèle, éventuellement augmentée par la pondération évoquée plus haut si le nuage de points est étalé le long de la parabole.

Pour chaque triplet (IPa ; IPb ; IPc), on reporte le résultat du dénombrement, éventuellement pondéré, sous la forme d'une intensité associée au point correspondant dans l'espace des valeurs (IPa ; IPb ; IPc). Sur une interface graphique, on représente des coupes de cet espace obtenues par exemple pour une valeur de IPc donnée et on utilise un code couleur ou une intensité lumineuse pour représenter l'intensité obtenue dans le plan (IPa ; IPb), coupe par coupe.

On a représenté sur la figure les résultats obtenus avec le deuxième mode de réalisation de l'invention, qui vient d'être présenté. On obtient cette fois des résultats cohérents, avec une incertitude faible.

Un opérateur humain ou un algorithme procède alors à la sélection, sur la base des intensités dans l'espace (IPa ; IPb ; IPc), d'un ou de plusieurs points correspondant à un ou plusieurs modèles du nuage de points selon l'équation (1). La sélection est effectuée pour la gestion du gisement ou du stockage considéré.

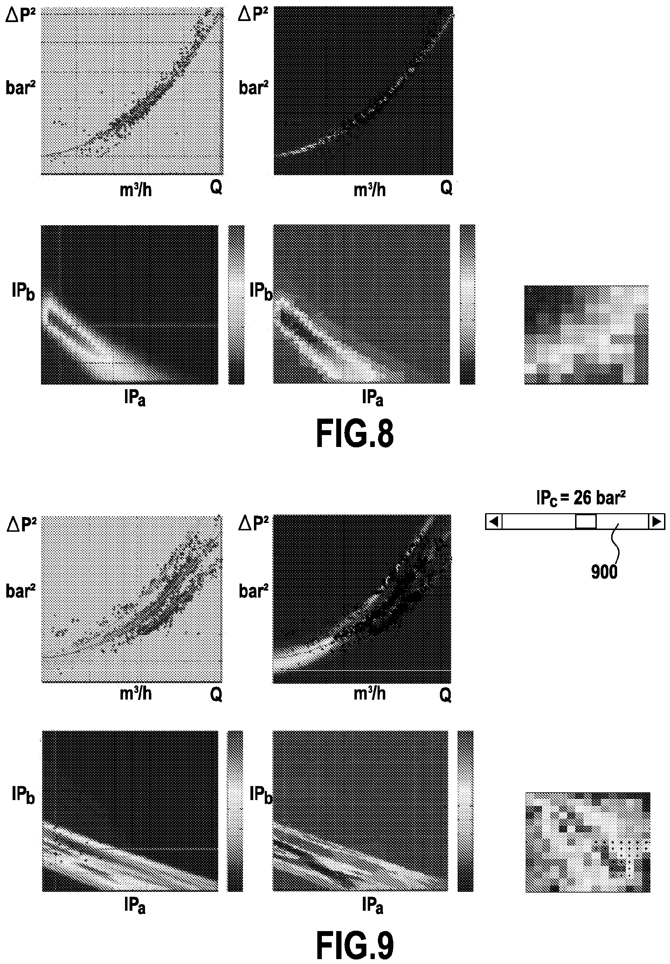

En **figure 8,** on a représenté l'interface graphique d'un logiciel, appelé RADON IP, et mettant en oeuvre l'invention, dans le mode de réalisation basé sur l'équation (2). On reconnait, dans la partie supérieure gauche, l'espace (Q ; $\Delta P^2$) dans lequel est représenté le nuage de points de mesure.

Dans la partie inférieure gauche, l'espace (IPa ; IPb) est présenté. Les valeurs d'intensité élevées forment une zone de géométrie simple, avec une ligne de crête unique. On a représenté le résultat d'un pointé automatique du maximum des valeurs d'intensité. La courbe correspondante est représentée dans l'espace (Q ; $\Delta P^2$) de la partie supérieure gauche de la figure, et on peut vérifier qu'elle passe bien par le point (Q = 0 ; $\Delta P^2$).

Dans la partie supérieure droite, le résultat de la transformée inverse est présenté. On voit ici que l'incertitude sur le modèle obtenu est très faible.

Enfin, dans la partie inférieure gauche, on a représenté l'espace (IPa ; IPb) avec une répartition des points par classes d'intensité, les classes étant délimitées par des seuils.

Dans la partie inférieure droite, on a segmenté l'espace (IPa,IPb) en classes de productivités avec une méthode de classification en cartes topologiques (par exemple SOM pour « Self Organizing Map » - carte autoadaptative ou autres méthodes apparentées), la projection des classes dans cette carte topologique est reproduite dans la partie extrême droite. Cette projection permet de sélectionner plus facilement des modèles connexes ou apparentés.

En **figure 9,** on a représenté la même interface graphique de logiciel mettant en oeuvre l'invention, mais cette fois dans le mode de réalisation basé sur l'équation (1). On reconnait, dans la partie supérieure gauche, l'espace (Q ; $\Delta P^2$) dans lequel est représenté le nuage de points de mesure. Le nuage est plus complexe que celui de la figure 8.

Dans la partie inférieure gauche, l'espace (IPa ; IPb) est présenté pour une valeur de IPc donnée, sélectionnée par l'utilisateur avec une barre coulissante 900 en haut à droite de la fenêtre de l'interface (ici une valeur de IPc = 26 $bar^2$ a été sélectionnée). Les valeurs d'intensité élevées forment une zone de géométrie complexe, avec plusieurs lignes de crêtes et plusieurs zones de valeurs élevées non connexes. Les courbes correspondantes sont représentées dans l'espace (Q ; $\Delta P^2$) de la partie supérieure gauche de la figure. On peut vérifier qu'elles ne passent, en général, pas par le point (Q = 0 ; $\Delta P^2$). Plus précisément, sur la figure 9, elles passent par le point (Q =0 ; $\Delta P^2$ = 26 $bar^2$) et qu'elles permettent de reproduire l'hétérogénéité du nuage de points, avec trois tendances qui apparaissent pour les valeurs de Q élevées, correspondant chacune à une gamme de valeurs de IPb différente.

Dans la partie supérieure gauche, le résultat de la transformée inverse est à nouveau présenté. On voit ici que l'incertitude sur le modèle obtenu est élevée, et on retrouve les trois tendances évoquées plus haut.

Dans un troisième mode de réalisation de l'invention (non représenté), on utilise une écriture modifiée de l'équation (1), comme suit.

$$\Delta P^2 / Q^2 = IPa / Q + IPb + IPc / Q^2 \quad (3)$$

Cette équation (3) est intéressante si l'hypothèse selon laquelle le point (Q = 0 ; Pm = Pg) est un point de fonctionnement n'est pas réalisée. Elle est qualifiée de modèle hyperbolique.

Un opérateur humain choisit des bornes inférieures et supérieures pour les coefficients IPa, IPb et IPc, et pour chaque triplet de coefficients (IPa ; IPb ; IPc) dans le cadre de ces bornes, l'hyperbole d'équation y = IPa / x + IPb + IPc /x² est considérée.

Un dénombrement des points dont la distance à l'hyperbole considérée, dans l'espace (Q ; $\Delta P^2/Q^2$), est inférieure à une valeur prédéterminée est effectué, pour connaître le nombre de points reproduits par le modèle. On effectue ensuite une sélection d'un ou plusieurs modèles pour la gestion du stockage ou du gisement concerné sur la base des dénombrements, par exemple en choisissant les points (IPa ; IPb ; IPc) pour lequel le dénombrement est le maximum.

Dans un quatrième mode de réalisation (également non représenté), on applique au nuage de point dans l'espace (Q ; $\Delta P^2/Q$) une transformée de Radon, ce qui fournit des intensités dans un espace en coordonnées polaires à deux dimensions. Puis on convertit les coordonnées polaires en coordonnées cartésiennes, de manière à obtenir des intensités dans un espace de coordonnées cartésiennes (X ; Y), dans lequel on sélectionne un point, sur la base des intensités, pour modéliser le nuage de points.

L'invention n'est pas limitée aux modes de réalisation décrits et s'étend à toutes les variantes dans le cadre de la portée des revendications. Notamment des modèles non basés sur l'équation (1) peuvent être utilisés, pour autant qu'ils soient satisfaisants sur le plan de la physique des stockages.

## Revendications

**1.** Procédé de caractérisation de la performance de puits d'un stockage ou gisement (1) de fluide compressible, comprenant des étapes

- d'obtention d'une pluralité de points de fonctionnement (400),
- de définition d'une famille de modèles de fonctionnement (IPa, IPb ; IPa, IPb, IPc),
- de dénombrement (410), pour chaque modèle de la famille, des points de la pluralité de points reproduits par ledit modèle,
- et de sélection (420) pour la gestion dudit stockage ou gisement d'au moins un modèle (M) dans la famille de modèles sur la base d'au moins le résultat de l'étape de dénombrement.

**2.** Procédé de caractérisation selon la revendication 1, dans lequel les points sont visualisés dans un espace de points d'abscisse proportionnelle à un débit d'exploitation (Q), et d'ordonnée proportionnelle à la différence entre le carré d'une pression de puits en exploitation et le carré d'une pression de puits au repos ($\Delta P^2$).

**3.** Procédé de caractérisation selon la revendication 1 ou la revendication 2, dans lequel la famille de modèles est paramétrée par deux valeurs numériques réelles.

**4.** Procédé de caractérisation selon la revendication 3, dans lequel les modèles de la famille sont des modèles linéaires.

**5.** Procédé de caractérisation selon la revendication 3, dans lequel les étapes de définition et de dénombrement comprennent une application de la transformée de Radon à la pluralité de points.

**6.** Procédé de caractérisation selon la revendication 1 ou la revendication 2, dans lequel la famille de modèles est paramétrée par trois valeurs numériques réelles.

**7.** Procédé de caractérisation selon la revendication 6, dans lequel les modèles de la famille sont des modèles paraboliques.

**8.** Procédé de caractérisation selon la revendication 6, dans lequel les modèles de la famille sont des modèles hyperboliques.

**9.** Procédé de caractérisation selon l'une des revendications 1 à 8, dans lequel un résultat de dénombrement est pondéré de manière à être plus important si des points reproduits par le modèle sont dispersés le long du modèle.

10. Procédé de caractérisation selon l'une des revendications 1 à 9, dans lequel la sélection est faite de manière au moins partiellement automatique.

11. Procédé de caractérisation selon l'une des revendications 1 à 10, dans lequel la sélection est faite de manière au moins partiellement manuelle par un opérateur humain.

12. Procédé de caractérisation selon l'une des revendications 1 à 11, dans lequel la sélection comprend une identification d'au moins un maximum des résultats de dénombrement.

13. Procédé de pilotage des débits ou pression de puits d'un stockage ou gisement de fluide compressible, utilisant un modèle sélectionné selon un procédé selon l'une des revendications 1 à 12.

14. Programme d'ordinateur comportant des instructions, qui, quand elles sont exécutées par un processeur, conduisent à la mise en oeuvre d'un procédé selon l'une des revendications 1 à 12.


**Patentansprüche**

1. Verfahren zur Charakterisierung der Bohrlochleistung einer Speicherung oder einer Lagerstätte (1) von kompressiblem Fluid, umfassend Schritte

   - des Erhaltens von mehreren Betriebspunkten (400),
   - des Definierens von einer Familie von Betriebsmodellen (IPa, IPb; IPa, IPb, IPc),
   - des Zählens (410) für jedes Modell der Familie der Punkte der mehreren Punkte, die von dem Modell wiedergegeben werden,
   - und des Auswählens (420) zum Verwalten der Speicherung oder Lagerstätte von mindestens einem Modell (M) aus der Familie von Modellen auf der Basis von mindestens dem Ergebnis des Schrittes des Zählens.

2. Verfahren zur Charakterisierung gemäß Anspruch 1, wobei die Punkte in einem Raum von Punkten mit Abszisse, die proportional zu einer Betriebsfördermenge (Q) ist, und mit Ordinate, die proportional zu der Differenz zwischen dem Quadrat eines Drucks eines Bohrlochs im Betrieb und dem Quadrat eines Drucks eines Bohrlochs in Ruhe ($\Delta P^2$) angezeigt werden.

3. Verfahren zur Charakterisierung gemäß Anspruch 1 oder 2, wobei die Familie von Modellen durch zwei tatsächliche Zahlenwerte parametriert wird.

4. Verfahren zur Charakterisierung gemäß Anspruch 3, wobei die Modelle der Familie lineare Modelle sind.

5. Verfahren zur Charakterisierung gemäß Anspruch 3, wobei die Schritte des Definierens und des Zählens eine Anwendung der Radontransformation auf die mehreren Punkte aufweisen.

6. Verfahren zur Charakterisierung gemäß Anspruch 1 oder 2, wobei die Familie von Modellen durch drei tatsächliche Zahlenwerte parametriert wird.

7. Verfahren zur Charakterisierung gemäß Anspruch 6, wobei die Modelle der Familie parabolische Modelle sind.

8. Verfahren zur Charakterisierung gemäß Anspruch 6, wobei die Modelle der Familie hyperbolische Modelle sind.

9. Verfahren zur Charakterisierung gemäß einem der Ansprüche 1 bis 8, wobei ein Ergebnis des Zählens derart gewichtet wird, um wichtiger zu sein, wenn die Punkte, die vom Modell wiedergegeben werden, entlang des Modells verstreut sind.

10. Verfahren zur Charakterisierung gemäß einem der Ansprüche 1 bis 9, wobei das Auswählen mindestens teilweise automatisch durchgeführt wird.

11. Verfahren zur Charakterisierung gemäß einem der Ansprüche 1 bis 10, wobei das Auswählen mindestens teilweise manuell von einem menschlichen Operator durchgeführt wird.

**12.** Verfahren zur Charakterisierung gemäß einem der Ansprüche 1 bis 11, wobei das Auswählen ein Identifizieren von mindestens einem Maximum der Zählungsergebnisse aufweist.

**13.** Verfahren zum Steuern der Fördermengen oder des Bohrlochdrucks einer Speicherung oder einer Lagerstätte von kompressiblem Fluid, das ein Modell verwendet, das nach dem Verfahren gemäß einem der Ansprüche 1 bis 12 ausgewählt wird.

**14.** Computerprogramm, das Anweisungen aufweist, die, wenn sie von einem Prozessor ausgeführt werden, zum Umsetzen eines Verfahrens gemäß einem der Ansprüche 1 bis 12 führen.

**Claims**

**1.** A characterization method for characterizing the performance of wells of a storage or of a deposit (1) of compressible fluid, the method comprising the steps of:

- obtaining a plurality of operating points (400);
- defining a family of operating models (IPa, IPb; IPa, IPb, IPc);
- for each model of the family, enumerating (410) those points of the plurality of points that are reproduced by said model; and
- selecting, for managing said storage or deposit (420) at least one model (M) from the family of models on the basis of at least the result of the enumeration step.

**2.** A characterization method according to claim 1, wherein the points are viewed in a space of points, said point having its abscissa proportional to a working flow rate (Q) and having its ordinate proportional to the difference between the square of a pressure of a working well and the square of a pressure of a well at rest ($\Delta P^2$).

**3.** A characterization method according to claim 1 or claim 2, wherein the family of models has, as parameters, two real numerical values.

**4.** A characterization method according to claim 3, wherein the models of the family are linear models.

**5.** A characterization method according to claim 3, wherein the defining and enumerating steps comprise applying the Radon transform to the plurality of points.

**6.** A characterization method according to claim 1 or claim 2, wherein the family of models has, as parameters, three real numerical values.

**7.** A characterization method according to claim 6, wherein the models of the family are parabolic models.

**8.** A characterization method according to claim 6, wherein the models of the family are hyperbolic models.

**9.** A characterization method according to any one of claims 1 to 8, wherein the enumeration result is weighted so as to be greater if the points reproduced by the model are dispersed along the model.

**10.** A characterization method according to any one of claims 1 to 9, wherein the selection is made in a manner that is automatic, at least in part.

**11.** A characterization method according to any one of claims 1 to 10, wherein the selection is made in a manner that is manual, at least in part, by a human operator.

**12.** A characterization method according to any one of claims 1 to 11, wherein the selection comprises identifying at least one maximum of the results of enumerating.

**13.** A method of controlling flow rates or pressure in a well of a storage or of a deposit of a compressible fluid, the method using a model selected by a method according to any one of claims 1 to 12.

**14.** A computer program including instructions that, when executed by a processor, leads to performing a method according to any one of claims 1 to 12.

FIG.1

FIG.2

FIG.3

**FIG.4**

**FIG.5**

FIG.6

FIG.7a

FIG.7b

**FIG.8**

$IP_C = 26 \ bar^2$

900

**FIG.9**

## RÉFÉRENCES CITÉES DANS LA DESCRIPTION

**Documents brevets cités dans la description**

- EP 2253797 A
- US 20090276100 A

- WO 2009082564 A

**Littérature non-brevet citée dans la description**

- On the détermination of functions from their integrals along certain manifolds 1917. **J. RADON.** The radon transform and some of its applications, Annexe A. John Wiley & Sons, 1983